# EUROPÄISCHE PATENTSCHRIFT

(11) **EP 2 676 532 B1**
(45) Veröffentlichungstag und Bekanntmachung des Hinweises auf die Patenterteilung: **31.05.2017**
(21) Anmeldenummer: 12709025.6
(22) Anmeldetag: 15.02.2012
(51) Int. Cl.: H05K 7/20, F04D 25/08

(54) **TEMPERIERELEMENT UND VERFAHREN ZUR BEFESTIGUNG EINES ELEKTROBAUTEILS AN DEM TEMPERIERELEMENT**
TEMPERATURE CONTROL ELEMENT AND METHOD FOR ATTACHING AN ELECTRONIC COMPONENT TO THE TEMPERATURE CONTROL ELEMENT
ÉLÉMENT DE RÉGULATION DE TEMPÉRATURE ET PROCÉDÉ POUR FIXER UN COMPOSANT ÉLECTRIQUE SUR LEDIT ÉLÉMENT

(30) Priorität: 15.02.2011 DE 102011004171
(43) Veröffentlichungstag der Anmeldung: 25.12.2013
(73) Patentinhaber: Brose Fahrzeugteile GmbH & Co. Kommanditgesellschaft, Würzburg, 97076 Würzburg (DE)
(72) Erfinder: MANTEY, Andy, 96352 Gifting (DE); DIPPOLD, Johannes, 96052 Bamberg (DE)
(74) Vertreter: Isarpatent
(86) Internationale Anmeldenummer: PCT/EP2012/052576
(87) Internationale Veröffentlichungsnummer: WO 2012/110551

(56) Entgegenhaltungen:
- WO-A1-00/01054
- WO-A1-2007/140494
- WO-A1-2009/092851
- DE-B- 1 166 584

## Beschreibung

### GEBIET DER ERFINDUNG

Die vorliegende Erfindung betrifft ein Temperierelement. Die vorliegende Erfindung betrifft ferner ein Verfahren zur Befestigung eines Elektrobauteils an dem Temperierelement.

### TECHNISCHER HINTERGRUND

In der Elektronikfertigung werden unter anderem Spritzgussteile mit einer speziellen Oberflächenbeschaffenheit und Oberflächenreinheit verwendet. An diesen Spritzgussteilen, beispielsweise einem Gehäuse eines Kühlerlüftermotors eines Fahrzeugs, werden elektrische Bauteile befestigt. Die elektrischen Bauteile können dabei über ein Kühlelement gekühlt werden. Hierbei können jedoch verschiedene Probleme auftreten. So kann es zu einem Kurzschluss zwischen dem elektrische Bauteil und dem Spritgussgehäuse kommen, wenn das elektrische Bauteil nicht geeignet elektrisch isoliert an dem Spritzgussgehäuse angebracht ist. Des Weiteren kann das elektrische Bauteil nur unzureichend gekühlt und dadurch beschädigt werden, wenn das elektrische Bauteil gegenüber dem Spritzgussgehäuse des Kühlerlüftermotors thermisch isoliert ist, da der Abstand zwischen dem elektrischen Bauteil und dem Spritzgussgehäuse des Kühlerlüftermotors zu groß ist aufgrund beispielsweise von Unebenheiten des Gehäuses. Dadurch besteht eine schlechte Wärmeleitfähigkeit zwischen dem elektrischen Bauteil und dem Spritzgussgehäuse.

Dies ist ein Zustand, den es zu verbessern gilt.

Aus der WO 2009/092851 A1 ist ein Verfahren bekannt, bei welchem einzelne zu kühlende Elektronikkomponenten mit einem Kühlelement ohne eine Leiterplatte oder ein Substrat verbunden werden. Bei dem Verfahren wird eine Schicht aus einem Isoliermaterial auf eine Oberfläche des Kühlelements thermisch aufgespritzt. Die Verbindungspunkte und Leiter, die von den einzelnen Elektronikkomponenten benötigt werden, werden auf der Isolierschicht ausgebildet.

In der WO 2007/140494 A1 ist ein Schaltungsträger offenbart, welche ein metallisches Trägermaterial aufweist. Wenigstens einige Abschnitte des Trägermaterials sind mit einer dielektrischen Schicht versehen.

Des Weiteren ist in der DE 11 66 584 B ein Verfahren zur Herstellung von Überzügen mit hoher Widerstandsfestigkeit gegenüber starken Temperaturschwankungen bekannt, durch Aufspritzen eines geschmolzenen feuerfesten Metalloxyds auf den zu überziehenden Gegenstand. Dabei wird eine Metallspritzpistole eingesetzt. Metall in Form eines Stabes oder Drahtes wird durch die Pistole geschmolzen, durch einen Gasstrom fein verteilt und versprüht und in Form von getrennten geschmolzenen Teilchen, die an Ort und Stelle erstarren, auf eine Oberfläche gespritzt.

In der WO 00/01054 ist eine Lagerschildanordnung offenbart für einen elektrisch kommutierten Motor. Die Lagerschildanordnung weist dabei eine Steuerungsanordnung auf, welche einen thermischen Pad aufweist. Der thermische Pad stellt dabei einen thermischen Kontakt zwischen einem Transistor und dem Lagerschild bereit, so dass das Lagerschild Wärme des Transistors abführen kann.

### ZUSAMMENFASSUNG DER ERFINDUNG

Vor diesem Hintergrund liegt der vorliegenden Erfindung die Aufgabe zugrunde, eine verbesserte Befestigung eines Elektrobauteils an einem Kühlelement bereitzustellen.

Erfindungsgemäß wird diese Aufgabe durch ein Temperierelement mit den Merkmalen des Patentanspruchs 1 und/oder durch ein Verfahren mit den Merkmalen des Patentanspruches 10 gelöst. Demgemäß ist vorgesehen:
- Temperierelement, mit wenigstens einem Oberflächenbereich, welcher eine Oberflächenrauigkeit in einem Bereich von Rz = 20µm bis Rz = 60µm aufweist, mit einer elektrisch isolierenden und thermisch leitfähigen Beschichtung, insbesondere einer Keramikbeschichtung, welche auf dem Oberflächenbereich vorgesehen ist, mit wenigstens einem Elektrobauteil, welches auf der Beschichtung befestigt ist, welches an das Temperierelement thermisch angebunden ist und welches gegenüber dem Temperierelement elektrisch isoliert ist.
- Verfahren zum Befestigen wenigstens eines Elektrobauteils an einem Temperierelement, mit den Schritten: Bereitstellen eines Temperierelements; Ausbilden wenigstens eines Oberflächenbereichs des Temperierelements mit einer Oberflächenrauigkeit in einem Bereich von R z = 20µm bis Rz = 60µm, Aufbringen einer elektrisch isolierenden und thermisch leitfähigen Beschichtung, insbesondere einer Keramikbeschichtung, auf den wenigstens einen Oberflächenbereich des Temperierelements; Befestigen wenigstens eines Elektrobauteils auf der Beschichtung des Temperierelements, wobei das Elektrobauteilthermisch an das Temperierelement angebunden und elektrisch gegenüber dem Temperierelement isoliert ist.

Die der vorliegenden Erfindung zugrunde liegende Erkenntnis/Idee besteht darin, ein Temperierelement mit einer elektrisch isolierenden und thermisch leitfähigen Beschichtung, insbesondere einer Keramikbeschichtung, zu versehen, um ein Elektronikbauteil daran zu befestigen, so dass das Elektronikbauteil einerseits thermisch an das Temperierelement angebunden werden kann und andererseits aber auch elektrisch isoliert gegenüber dem Temperierelement ist.

Vorteilhafte Ausgestaltungen und Weiterbildungen ergeben sich aus den weiteren Unteransprüchen sowie aus der Beschreibung unter Bezugnahme auf die Figuren der Zeichnung.

In einer erfindungsgemäßen Ausführungsform ist der wenigstens eine Oberflächenbereich durch eine Strahltechnik, insbesondere Sandstrahlen, Strahlen mit Korund, Kugelstrahlen, Metallstrahlen und/oder Glasstrahlen, behandelt. Dies hat den Vorteil, dass beispielsweise Unebenheiten, wie Grate, von dem Oberflächenbereich entfernt und der Oberflächenbereich z.B. mit einer vorbestimmten oder definierten Oberflächenrauigkeit versehen werden kann. Dies verbessert zusätzlich die Haftung der Beschichtung oder einer zusätzlichen Zwischenschicht. Erfindungsgemäß weist der wenigstens eine Oberflächenbereich durch die Behandlung mit der Strahltechnik eine definierte Oberflächenrauigkeit auf, vorzugsweise eine Oberflächenrauigkeit in einem Bereich von R_{Z} = 20µm bis R_{z} = 60µm. Auf diese Weise kann die Haftung der anschließend aufgebrachten Beschichtung oder zusätzlichen Zwischenschicht weiter verbessert werden.

Gemäß einer Ausführungsform der Erfindung ist der wenigstens eine Oberflächenbereich mit wenigstens einer Zwischenschicht versehen, wobei die Zwischenschicht insbesondere als Haftgrund ausgebildet ist für die Beschichtung. Die Zwischenschicht verbessert ebenfalls die Haftung der Beschichtung.

In einer Ausführungsform der Erfindung ist die Zwischenschicht eine Metalllegierung und insbesondere z.B. eine Nickel, Chrom, Kupfer und/oder Aluminiumlegierung.

Gemäß einer weiteren erfindungsgemäßen Ausführungsform ist die Zwischenschicht durch thermisches Spritzen auf den wenigstens einen Oberflächenbereich aufgebracht. Das thermische Spritzen hat den Vorteil, dass der Oberflächenbereich kaum thermisch belastet wird.

In einer erfindungsgemäßen Ausführungsform wird die elektrisch isolierende und thermisch leitfähige Beschichtung, insbesondere eine Keramikbeschichtung, z.B. eine Elektrokeramikbeschichtung, auf den Oberflächenbereich derart aufgetragen Unebenheiten und/oder Unreinheiten des Oberflächenbereichs auszugleichen. Auf diese Weise können Unebenheiten in der Oberfläche, die sonst in einer verschlechterten thermischen Anbindung des Elektrobauteils resultieren, zumindest teilweise oder vollständig ausgeglichen und egalisiert werden. Des Weiteren können Unreinheiten der Oberfläche ausgeglichen werden, die sonst u.U. zu Kurzschlüssen mit dem Elektrobauteil führen könnten.

In einer weiteren erfindungsgemäßen Ausführungsform ist das Elektrobauteil mittels eines thermischen Interface Materials oder thermischen Verbindungsmaterials, wie z.B. einer Wärmeleitpaste, insbesondere einem Glaskugelkleber oder einer anderen Wärmeleitpaste, an dem Oberflächenbereich mit der elektrisch isolierenden und thermisch leitfähigen Beschichtung angebunden. Das thermische Interface Material oder thermische Verbindungsmaterial, wie z.B. die Wärmeleitpaste, hat den Vorteil, dass das Elektrobauteil sehr einfach thermisch an das Temperierelement angebunden werden kann. Die elektrisch isolierende und thermisch leitfähige Beschichtung, insbesondere eine Keramikbeschichtung wie eine Elektrokeramikbeschichtung, weist ebenfalls eine sehr gute Wärmeleitfähigkeit auf und elektrisch isoliert gleichzeitig das Elektrobauteil gegenüber dem Temperierelement.

In einer weiteren erfindungsgemäßen Ausführungsform ist die Beschichtung, z.B. eine Keramikbeschichtung wie eine Elektrokeramik, aus Aluminiumoxid, Al₂O₃, einem Gemisch aus 97% Al₂O₃ und 3% TiO₂, MgAl₂O₄ und/oder Magnesiumoxid. Aluminiumoxid zeichnet sich durch herausragende Werkstoffeigenschaften aus, wie z.B. elektrische Isolationsfestigkeit bei hohen Temperaturen. Magnesiumoxid zeichnet des Weiteren durch ein gutes elektrisches Isolationsvermögen bei hohen Temperaturen bei gleichzeitig sehr guter Wärmeleitfähigkeit aus.

In einer anderen erfindungsgemäßen Ausführungsform wird die elektrisch isolierende und thermisch leitfähige Beschichtung, z.B. eine Keramikbeschichtung, wie eine Elektrokeramikbeschichtung usw., als Granulat (z.B. Keramikgranulat) mittels eines Plasmastrahls auf den Oberflächenbereich des Temperierelements aufgetragen zum Beschichten des Oberflächenbereichs. Dabei wird die Beschichtung durch den Plasmastrahl gleichzeitig in der Oberfläche aufgetragen und eine sehr stabile Beschichtung der Oberfläche erreicht. Neben dem Plasmaspritzen können auch weitere thermische Spritzverfahren, wie z.B. das Flammspritzen, insbesondere das Hochgeschwindigkeits-Flammspritzen, usw., zum Aufbringen der Beschichtung eingesetzt werden.

Gemäß einer anderen erfindungsgemäßen Ausführungsform ist das Temperierelement ein Kühlelement, insbesondere ein Gehäuse eines Lüfterkühlermotors eines Fahrzeugs. Der Lüfterkühlermotor kann so genutzt werden, um die Wärme, die durch das an ihm befestigte Elektrobauteil erzeugt, aufzunehmen und abzuführen.

Die obigen Ausgestaltungen und Weiterbildungen lassen sich, sofern sinnvoll, beliebig miteinander kombinieren.

### INHALTSANGABE DER ZEICHNUNG

Die vorliegende Erfindung wird nachfolgend anhand der in den schematischen Figuren der Zeichnungen angegebenen Ausführungsbeispiele näher erläutert. Es zeigen dabei:
- Fig. 1: ein Ausschnitt einer Verbindung eines Kühlelements mit elektrische Bauelementen in einer Schnittansicht gemäß einer ersten Ausführungsform der Erfindung;
- Fig. 2: ein Ausschnitt einer Verbindung eines Kühlelements mit elektrische Bauelementen in einer Schnittansicht gemäß einer zweiten Ausführungsform der Erfindung;
- Fig. 3: eine Draufsicht auf ein Gehäuse eines Kühlerlüftermotors eines Fahrzeugs, mit einer vollflächigen Keramikbeschichtung;
- Fig. 4: eine Draufsicht auf ein Gehäuse eines Kühlerlüftermotors eines Fahrzeugs, mit einer Keramikbeschichtung von Funktionsflächen;
- Fig. 5: ein Ablaufdiagramm zum Verbinden oder Befestigen eines Elektrobauteils an einem Kühlelement gemäß der ersten Ausführungsform der Erfindung; und
- Fig. 6: ein Ablaufdiagramm zum Verbinden oder Befestigen eines Elektrobauteils an einem Kühlelement gemäß der zweiten Ausführungsform der Erfindung.

Die beiliegenden Zeichnungen sollen ein weiteres Verständnis der Ausführungsformen der Erfindung vermitteln. Sie veranschaulichen Ausführungsformen und dienen im Zusammenhang mit der Beschreibung der Erklärung von Prinzipien und Konzepten der Erfindung. Andere Ausführungsformen und viele der genannten Vorteile ergeben sich im Hinblick auf die Zeichnungen. Die Elemente der Zeichnungen sind nicht notwendigerweise maßstabsgetreu zueinander gezeigt.

In den Figuren der Zeichnung sind gleiche, funktionsgleiche und gleich wirkende Elemente, Merkmale und Komponenten - sofern nichts Anderes ausführt ist -jeweils mit denselben Bezugszeichen versehen.

### BESCHREIBUNG VON AUSFÜHRUNGSBEISPIELEN

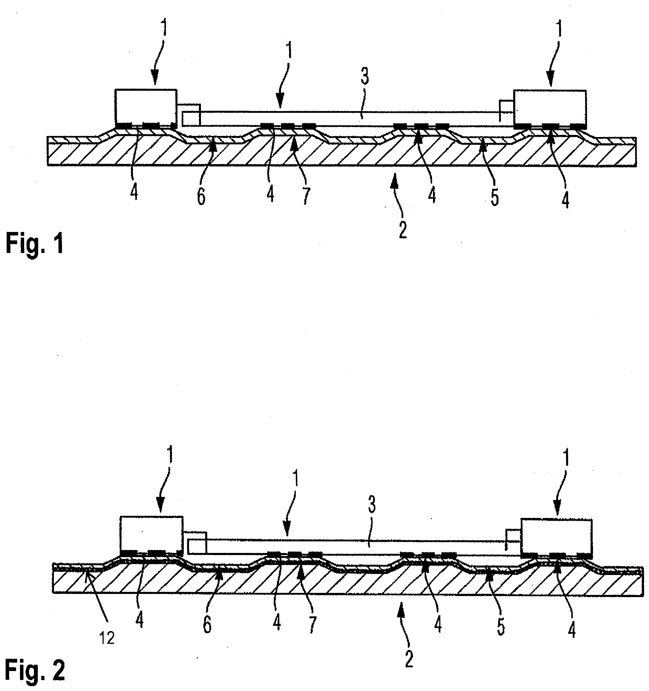

Fig. 1 zeigt die Befestigung von mehreren Elektrobauteilen 1 an einem Temperierelement 2, hier z.B. einem Kühlelement, in einer Schnittansicht gemäß einer ersten Ausführungsform der Erfindung.

Fig. 2 zeigt des Weiteren die Befestigung von mehreren Elektronikbauteilen 1 an einem Temperierelement 2 in einer Schnittansicht gemäß einer zweiten Ausführungsform der Erfindung.

Die erste und zweite Ausführungsform der Erfindung unterscheiden sich dadurch, dass bei der zweiten Ausführungsform eine zusätzliche Zwischenschicht 12 als Haftgrund auf dem Temperierelement 2, hier z.B. dem Kühlelement, aufgebracht ist.

Die beiden Schnittansichten der Elektrobauteile 1 und des Kühlelements 2 sind rein schematisch, nicht maßstäblich und stark vereinfacht dargestellt.

Elektrobauteile 1 oder Leistungs-Bauelemente die Wärme übertragen, wie beispielsweise Transistoren, FETs, Spannungsregler, Leiterplatten 3 mit Schaltungen und Bauelementen usw., können zur Kühlung an einem Kühlelement 2 thermisch angebunden werden. Dazu werden die Elektrobauteile 1 durch ein thermisches Interface Material oder thermisches Verbindungsmaterials, wie z.B. eine Wärmeleitpaste 4 (mit einer gestrichelten Linie in Fig. 1 angedeutet) an dem Kühlelement 2 angebunden. In Fig. 1 wird eine Wärmeleitpaste 4 eingesetzt. Die Erfindung ist aber nicht auf eine Wärmeleitpaste beschränkt. Es kann jedes andere thermische Interface Material oder thermisches Verbindungs- oder Anbindungsmaterial eingesetzt werden.

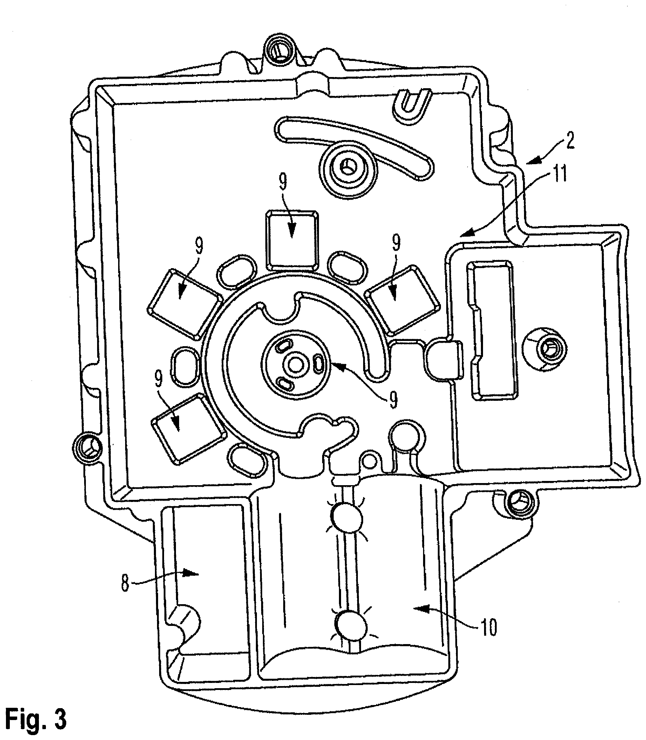

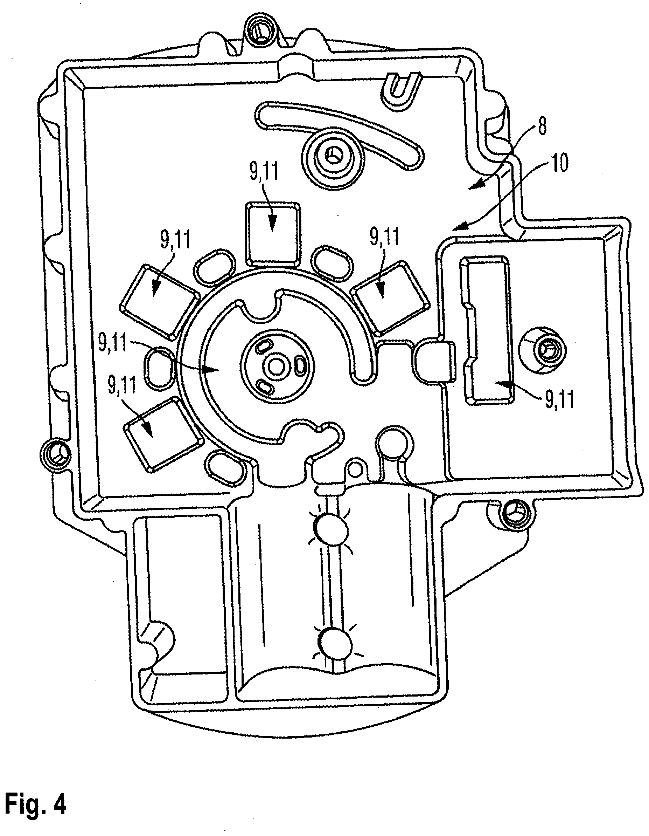

Das Kühlelement 2 ist beispielsweise ein Gehäuse, insbesondere ein Gehäuse eines Kühlerlüftermotors, wie z.B. ein Spritzgussgehäuse eines Kühlerlüftermotors eines Fahrzeugs, wie in nachfolgenden Fig. 3 und 4 gezeigt ist. Die Erfindung ist jedoch nicht auf ein Gehäuse eines Kühlerlüftermotors oder ein Spritzgussgehäuse beschränkt.

Als Wärmeleitpaste 4 zum Anbinden des jeweiligen Elektrobauteils 1, wird beispielsweise ein Glaskugelkleber eingesetzt oder eine andere Wärmeleitpaste oder Kombination von Wärmeleitpasten. Wie zuvor beschrieben kann neben einer Wärmeleitpaste auch jedes andere thermische Interface Material oder thermisches Verbindungs- oder Anbindungsmaterial eingesetzt werden.

Wie in Fig. 1 und 2 gezeigt ist, kann die Oberfläche des Kühlelements 1, z.B. ein Spritzgussgehäuse eines Kühlerlüftermotors eines Fahrzeugs, Unebenheiten 5 und/oder Unreinheiten aufweisen. Solche Unebenheiten 5 und Unreinheiten können dazu führen, dass bei einer Befestigung eines Elektrobauteils 1 ein Kurzschluss entstehen oder eine unzureichende thermische Anbindung des Elektrobauteils 1 an das Kühlelement 2 gegeben sein kann, so dass das Elektrobauteil 1 nicht ausreichend gekühlt werden kann.

Daher wird nun gemäß der Erfindung das Kühlelement 2 in wenigstens einem Oberflächenbereich oder die gesamte oder im Wesentlichen die gesamte Oberfläche mit einer Beschichtung versehen, wobei die Beschichtung so gewählt ist, dass sie einerseits elektrisch isolierend und andererseits thermisch leitfähig ist Anschließend wird das jeweilige Elektrobauteil 1 über ein thermisches Interface Material oder thermisches Verbindungsmaterial, wie z.B. die Wärmeleitpaste 4, an dem mit der Beschichtung 6 beschichteten Kühlelement 2 angebunden wie in den Fig. 1 und 2 gezeigt ist. Als Wärmeleitpaste 4 kann, wie zuvor beschrieben, dabei ein Glaskugelkleber eingesetzt werden. Statt dem Glaskugelkleber kann jedoch auch jede andere Wärmeleitpaste sowie jedes andere thermische Interface Material oder thermisches Verbindungs- oder Anbindungsmaterial eingesetzt werden. Insbesondere können auch im Vergleich zum Glaskugelkleber kostengünstigere Wärmeleitpasten verwendet werden.

Bei der ersten Ausführungsform der Erfindung, wie sie in Fig. 1 gezeigt ist, wird als Beispiel für eine elektrisch isolierende und thermisch leitfähige Beschichtung, eine Keramikbeschichtung, wie z.B. eine Elektrokeramikbeschichtung 6, direkt auf der Oberfläche des Kühlelements 2 aufgebracht.

In der zweiten Ausführungsform der Erfindung wird dagegen, wie in Fig. 2 gezeigt ist, zunächst wenigstens eine Zwischenschicht auf die Oberfläche des Kühlelements 2 aufgebracht, welche als Haftgrund für die elektrisch isolierende und thermisch leitfähige Beschichtung, hier z.B. die Elektrokeramikbeschichtung 6, dient. Anschließend wird die Elektrokeramikbeschichtung 6 auf die Zwischenschicht aufgebracht. Auf der Elektrokeramikbeschichtung 6 wird dann wenigstens ein Elektrobauteil 1 mittels einer Wärmeleitpaste 4.

Im Falle einer Keramikbeschichtung, wie z.B. einer Elektrokeramikbeschichtung, wird das Keramikmaterial zum Beschichten beispielsweise als Keramikgranulat mit Hochdruck in einen Plasmastrahl gesprüht, dadurch verflüssigt sich das Keramikgranulat und wird auf die Oberfläche des Bauteils, hier des Kühlelements 2 oder im Falle einer Zwischenschicht auf die Zwischenschicht des Kühlelements 2 aufgetragen oder aufgebracht.

Als Verfahren kann das sog. thermische Spritzen als Oberflächenbeschichtungsverfahren eingesetzt werden zum Auftragen der Beschichtung, wie der Keramikbeschichtung 6, auf das Bauteil 2. Gemäß der Erfindung kann als thermisches Spritzverfahren hierbei insbesondere das Hochgeschwindigkeits-Flammspritzen mit einem gasförmigen oder flüssigen Brennstoff und Plasmaspritzen, z.B. atmosphärisches Plasmaspritzen bzw. Plasmaspritzen mittels eines Plasmastrahls an Atmosphäre, Plasmaspritzen unter Schutzgas oder Plasmaspritzen unter niedrigem Druck (Vakuum), eingesetzt werden.

Das thermische Spritzen ist allgemein nach DIN EN 657 definiert. Beim thermischen Spritzen werden Zusatzwerkstoffe, die sog. Spritzzusätze oder Beschichtungswerkstoffe, innerhalb oder außerhalb eines Spritzgeräts oder -brenners an-, auf- oder abgeschmolzen, in einem Gasstrom in Form von Spritzpartikeln beschleunigt und auf die Oberfläche des zu beschichtenden Bauteils aufgeschleudert.

Die Bauteiloberfläche wird hierbei nicht aufgeschmolzen.

Wie zuvor beschrieben, dient als Energieträger für die An-, Ab- oder Aufschmelzung des Spritzzusatzwerkstoffes (Beschichtungswerkstoff) ein Plasmastrahl im Falle von Plasmaspritzen. Daneben können als Energieträger für die An-, Ab- oder Aufschmelzung des Spritzzusatzwerkstoffes (Beschichtungswerkstoff) auch ein elektrischer Lichtbogen im Falle von Lichtbogenspritzen, eine Brennstoff-Sauerstoff-Flamme bzw. Brennstoff-Sauerstoff-Hochgeschwindigkeitsflamme im Falle von konventionellem und Hochgeschwindigkeits-Flammspritzen, ein Laserstrahl im Falle von Laserstrahlspritzen sowie schnelle, vorgewärmte Gase im Falle von Kaltgasspritzen eingesetzt werden. Mittels dieser thermischen Spritzverfahren ist die Beschichtung metallischer und nichtmetallischer Werkstoffe mit z.B. oxidkeramischen Werkstoffen, Metallen, carbidischen Werkstoffen bzw. Verbundwerkstoffen usw. möglich.

Als Beispiel für eine elektrisch isolierende und thermisch leitfähige Beschichtung, z.B. eine Keramikbeschichtung, wie eine Elektrokeramikbeschichtung 6, kann beispielsweise Aluminiumoxid wie Rapox® der Fa. Rauschert, Korund oder Al₂O₃, ein Gemisch aus beispielsweise 97% Al₂O₃ bzw. Korund und 3% TiO₂ bzw. Titandioxid, MgAl₂O₄ oder Spinell, oder Magnesiumoxid usw. eingesetzt werden oder ein anderes geeignetes Keramikmaterial oder Keramikmaterialkombination. Rapox® der Fa. Rauschert ist eine Aluminiumoxidkeramik, die sich durch herausragende Werkstoffeigenschaften, wie z.B. elektrische Isolationsfestigkeit bei hohen Temperaturen auszeichnet. Ebenso kann z.B. Magnesiumoxid als Keramikbeschichtung 6 eingesetzt werden. Magnesiumoxid gehört zur Gruppe der Hochtemperatur-Keramikwerkstoffe. Es zeichnet sich durch ein gutes elektrisches Isolationsvermögen bei hohen Temperaturen bei gleichzeitig sehr guter Wärmeleitfähigkeit aus.

Die Beschichtung insbesondere wenigstens einer oder aller Funktionsbereiche der Oberfläche des Kühlelements 2, z.B. der Oberfläche des Spritzgussgehäuses, mit einer elektrisch isolierende und thermisch leitfähige Beschichtung, wie einer Elektrokeramikbeschichtung 6, hat den Vorteil, dass eine bessere Wärmeabfuhr des Elektrobauteils 1 und eine verbesserte elektrische Isolation des Elektrobauteils 1 gegenüber dem Kühlelement 2 erzielt werden kann. Durch die Beschichtung 6 können dabei beispielsweise, wie in den Ausführungsbeispielen in Fig. 1 und 2 gezeigt ist, Unebenheiten 5 können zumindest teilweise oder vollständig ausgeglichen, Restunebenheiten 7 beschichtet und zur Elektronik isoliert werden. Somit kann das Kühlelement 2 mit seiner Oberfläche zur Elektronik oder den Elektronikbauteilen 1 elektrisch isoliert werden, wobei außerdem eine ausreichende thermische Anbindung des Elektrobauteils 1 an das Kühlelement 2 erzielt werden kann.

Wie in den Ausführungsbeispielen in Fig. 1 und 2 gezeigt ist, kann eine flächige Beschichtung mit der elektrisch isolierende und thermisch leitfähigen Beschichtung, z.B. der Elektrokeramikbeschichtung 6, des kompletten oder im Wesentlichen kompletten Kühlelements 2, z.B. Spritzgussgehäuses eines Kühlerlüftermotors, oder zumindest eines Flächenbereichs des Kühlelements 2 erfolgen. Dabei kann in dem Ausführungsbeispiel in Fig. 2 die komplette oder im Wesentlichen komplette Fläche oder zumindest ein Flächenbereich mit der zusätzlichen Zwischenschicht und der elektrisch isolierenden und thermisch leitfähigen Beschichtung, z.B. der Elektrokeramikbeschichtung 6, versehen werden.

Anschließend kann in den in Fig. 1 und 2 illustrierten Ausführungsbeispielen als Elektrobauteil 1 wenigstens eine Leiterplatte 3 mit einem oder mehreren Bauelementen und/oder Schaltungen, z.B. einer Hybrid-Schaltung, usw. darauf, mittels eines thermischen Interface Materials oder thermischen Verbindungs- oder Anbindungsmaterials, wie z.B. einer Wärmeleitpaste 4, auf der beschichteten Oberfläche des Kühlelements 2 angebunden werden. Die Wärmeleitpaste 4, z.B. ein Glaskugelkleber, stellt lediglich ein Beispiel für ein thermisches Interface Material oder thermisches Verbindungs- oder Anbindungsmaterial dar. Die Erfindung ist auf eine Wärmeleitpaste und insbesondere auf einen Glaskugelkleber nicht beschränkt.

Neben einer Leiterplatte 3 als Elektrobauteil 1 können, wie in dem Ausführungsbeispiel in Fig. 1 und 2 gezeigt ist, weitere Elektrobauteile 1 auf der beschichteten Oberfläche des Kühlelements 2 durch eine Wärmeleitpaste 4 (als ein Beispiel für ein thermisches Interface Material)angebunden werden, wie z.B. Transistoren, FETs (Feldeffekttransitoren), Spannungsregler, eine Die, ein Chip, eine Leiterplatte (LP), eine Hybrid-Schaltung, eine bestückte Leiterplatte (engl. printed circuit board oder PCB), ein Stanzgitter, ein Stecker usw..

Die Erfindung ist auf diese speziellen Beispiele für Elektrobauteile 1 nicht beschränkt. Grundsätzlich kann jedes Elektrobauteil 1, wie ein elektrisches Bauelement, ein elektromechanisches Bauelement usw. auf der beschichteten Oberfläche des Temperierelements, hier z.B. Kühlelements 2, angebunden werden, so dass es einerseits seine Wärme an das Kühlelement 2 abführen kann und andererseits gegenüber dem Kühlelement 2 elektrisch isoliert ist, so dass ein Kurzschluss mit dem Kühlelement 2 verhindert werden kann.

Ebenso kann, wie zuvor beschrieben auch nur wenigstens ein Oberflächenbereich des Kühlelements 2 beschichtet werden. Das heißt, es erfolgt eine partielle Beschichtung vorzugsweise eine Beschichtung von Funktionsflächen d.h. Oberflächenbereichen, an welchem wenigstens ein Elektrobauteil 1 angebunden wird, insbesondere mittels eines thermische Interface Materials wie z.B. einer Wärmeleitpaste 4, wie in nachfolgender Fig. 3 beispielhaft gezeigt ist.

Die beschriebene Technik kann auf allen isolierenden und/oder thermisch angebundenen Temperierelementen 2, wie insbesondere Kühlelementen, Anwendung finden, wenn dort ein Bauteil 1 angebracht werden soll, dass einerseits elektrisch isoliert und andererseits thermisch an das Temperierelement 2 angebunden werden soll.

In den in Fig. 1 und 2 gezeigten Ausführungsform der Erfindung kann, bevor die elektrisch isolierende und thermisch leitfähige Beschichtung, z.B. die Elektrokeramikbeschichtung 6, auf die Oberfläche des zu beschichtenden Bauteils 2 aufgebracht wird, und zumindest der mit der Elektrokeramikbeschichtung 6 zu beschichtende Oberflächenbereich des Bauteils wahlweise zusätzlich vorbehandelt werden.

Dabei kann der mit der elektrisch isolierenden und thermisch leitfähigen Beschichtung, z.B. eine Keramikbeschichtung, wie eine Elektrokeramikbeschichtung 6, zu beschichtende Oberflächenbereich des Bauteils 2 beispielsweise durch eine Strahltechnik, z.B. mit Korund als Strahlmittel, vorbehandelt werden. Hierdurch können z.B. Grate an der Bauteiloberfläche entfernt und/oder eine vorbestimmte bzw. definierte Oberflächenrauheit des Bauteils 2 erzielt oder sichergestellt werden.

Dabei kann der mit der elektrisch isolierenden und thermisch leitfähigen Beschichtung, z.B. der Elektrokeramik 6, zu beschichtende Oberflächenbereich des Bauteils 2 beispielsweise mit einer Oberflächenrauigkeit in einem Bereich von Rz ± 40µm oder in einem Bereich von R_{Z} = 20µm bis R_{z} = 60µm versehen werden, wodurch die Haftung der Beschichtung 6 zusätzlich verbessert werden kann. Die Erfindung ist auf die beiden genannten Bereiche jedoch nicht beschränkt. Die Oberflächenrauigkeit ist vorzugsweise so gewählt, dass die Haftung der elektrisch isolierenden und thermisch leitfähigen Beschichtung, z.B. die Elektrokeramik 6, erhöht wird. Die Erfindung ist auf diesen Bereich von R_{Z} = 20µm bis R_{z} = 60µm nicht beschränkt. Die Rauigkeit wird vorzugsweise so gewählt, dass die Haftung der jeweils verwendeten elektrisch isolierenden und thermisch leitfähigen Beschichtung erhöht wird oder der Zwischenschicht, im Falle, dass eine zusätzliche Zwischenschicht als Haftgrund eingesetzt wird.

Statt Korund kann jedes andere Material oder jede andere Materialkombination als Strahlmittel eingesetzt werden zum Bestrahlen eines Oberflächenbereichs des Bauteils. Als Strahlverfahren kann Sandstrahlen, Kugelstrahlen, Metallstrahlen oder Glasstrahlen usw. eingesetzt werden. Auf diese Weise kann zumindest der mit der elektrisch isolierenden und thermisch leitfähigen Beschichtung, z.B. der Elektrokeramik 6, zu beschichtende Oberflächenbereich des Bauteils 2 mit einer vorbestimmten Rauigkeit versehen werden, die geeignet ist, anschließend die Haftung der Beschichtung, wie z.B. der Elektrokeramikbeschichtung 6, zu erhöhen.

Statt oder zusätzlich zu dem Vorbehandeln zumindest des mit der elektrisch isolierenden und thermisch leitfähigen Beschichtung 6 zu beschichtenden Oberflächenbereichs des Bauteils 2 mittels einer Strahltechnik und einem Strahlmittel, wie beispielsweise Korund, kann auch wenigstens eine zusätzliche Zwischenschicht 12 auf dem Bauteil oder dem Kühlelement aufgebracht werden, wie in Fig. 2 gezeigt ist.

Die Zwischenschicht 12 ist dabei zwischen der Bauteiloberfläche oder der Kühlelementoberfläche und der späteren elektrisch isolierenden und thermisch leitfähigen Beschichtung, z.B. der Elektrokeramikbeschichtung 6, vorgesehen. Als Material oder Materialkombination für die Zwischenschicht 12 wird ein Material oder eine Materialkombination verwendet, welche einen Haftgrund für die elektrisch isolierende und thermisch leitfähige Beschichtung, z.B. die Elektrokeramik 6, bildet.

Als Material für die Zwischenschicht 12 kann dabei beispielsweise ein Metall oder eine Metalllegierung, wie z.B. eine Ni/Al-Legierung oder eine Ni/Cr-Legierung, verwendet werden, da diese einen guten Haftgrund bilden. Des Weiteren kann die Zwischenschicht 12 eine Schichtdicke in einem Bereich von z.B. ± 10µm aufweisen. Mittels der Zwischenschicht 12 kann die Haftung der elektrisch isolierenden und thermisch leitfähigen Beschichtung, wie z.B. der Elektrokeramikbeschichtung 6, auf dem Bauteil oder dem Kühlelement 2 zusätzlich verbessert werden. Die Dicke der elektrisch isolierenden und thermisch leitfähigen Beschichtung 6 kann in den in den Fig. 1 und 2 gezeigten erfindungsgemäßen Ausführungsformen vorzugsweise in einem Bereich von 15µm bis 150µm liegen.

Die vorliegende Erfindung ist jedoch nicht auf die genannten Bereiche für die Schichtdicken der elektrisch isolierenden und thermisch leitfähigen Beschichtung, z.B. der Elektrokeramikbeschichtung 6, und der Zwischenschicht beschränkt.

In Fig. 3 ist eine Draufsicht auf ein Gehäuse 8 eines Kühlerlüftermotors eines Fahrzeugs gezeigt, als ein Beispiel für ein Temperierelement 2, hier ein Kühlelement. Dabei ist ein Teil der Oberfläche des Gehäuses 8 mit einer elektrisch isolierenden und thermisch leitfähigen Beschichtung, z.B. einer Elektrokeramik 6, beschichtet, wobei der Teil der Oberfläche dabei mehrere Funktionsflächen 9 aufweist, an denen anschließend ein oder mehrere Elektrobauteile angebunden werden mittels eines thermischen Interface Materials wie z.B. einer Wärmeleitpaste. Der Bereich 10 der Oberfläche des Gehäuses 8 des Kühlerlüftermotors wird abgedeckt oder maskiert, der nicht beschichtet werden soll, beispielweise mit einer Platte mit entsprechenden Öffnungen für die Funktionsflächen (nicht dargestellt). Wie zuvor beschrieben wird eine Elektrokeramik 6, wie Aluminiumoxid, als Keramikgranulat in einen Plasmastrahl gesprüht, dadurch verflüssigt sich das Keramikgranulat und wird auf die nicht abgedeckte zu beschichtende Oberfläche 11 des Gehäuses 8 aufgetragen oder aufgebracht, um diese mit einer keramischen Beschichtung 6 zu versehen.

Fig. 4 zeigt ebenfalls eine Draufsicht auf ein Gehäuse 8 eines Kühlerlüftermotors eines Fahrzeugs, mit einer elektrisch isolierenden und thermisch leitfähigen Beschichtung, beispielsweise einer Keramikbeschichtung 6, z.B. nur von Funktionsflächen 9. In dem in Fig. 4 gezeigten Ausführungsbeispiel werden ausschließlich Funktionsflächen 9 auf denen anschließend wenigstens ein Elektronikbauteil angebracht wird, mit einer Elektrokeramik 6 beschichtet.

Hierbei ist der Teil der Oberfläche des Gehäuses 8, welcher keine Funktionsfläche bildet, abgedeckt oder maskiert, beispielweise mit einer Platte mit entsprechenden Öffnungen für die Funktionsflächen (nicht dargestellt), um anschließend nur die Funktionsflächen 9 mit einer Keramikbeschichtung 6 zu versehen. Im Anschluss an die Beschichtung der Funktionsflächen 9 mit der Elektrokeramik 6 können dann ein oder mehrere Elektrobauteile auf den Funktionsflächen 9, z.B. mittels eines thermischen Interface Materials, z.B. einer Wärmeleitpaste, angebunden werden. Als eine Elektrokeramik 6 kann dabei ebenfalls z.B. Aluminiumoxid verwendet werden, welche als Keramikgranulat in einen Plasmastrahl gesprüht wird, wobei sich das Keramikgranulat verflüssigt und auf die nicht abgedeckten zu beschichtenden Funktionsflächen 9, 11 des Gehäuses 8 aufgesprüht wird, um diese mit einer keramischen Beschichtung zu versehen.

Bei den in den Fig. 3 und 4 gezeigten Ausführungsbeispielen kann zumindest der mit der elektrisch isolierenden und thermisch leitfähigen Beschichtung, z.B. der Elektrokeramik 6 als Keramikbeschichtung, zu versehende Oberflächenbereich des Gehäuses 8 optional mittels Strahltechnik (z.B. Sandstrahlen, Kugelstrahlen, Metallstrahlen, Glasstrahlen usw.) behandelt werden und/oder mit wenigstens einer zusätzlichen zwischenschicht 12 versehen werden, wie zuvor mit Bezug auf Fig. 2 beschrieben wurde.

Das Beschichten der Oberfläche 11 des Kühlelements 2 und das anschließende Befestigen eines Elektrobauteils an der beschichteten Oberfläche 11 hat den Vorteil, dass die thermische Anbindung des Elektrobauteils an das Kühlelement 2 verbessert und gleichzeitige eine elektrische Isolation des Elektrobauteils gegenüber dem Kühlelement 2 erzielt werden kann.

Ein weiterer Vorteil ist, dass zusätzliche Reinigungsprozesse wie Waschen oder Bürsten des Kühlelements 2, z.B. des Spritzgussgehäuses des Kühlerlüftermotors, weggelassen werden können. Des Weiteren können hohen Schrottkosten innerhalb der Produktion verhindert werden, die bisher aufgrund von Kurzschlüssen zwischen dem Elektrobauteil und dem Kühlelement 2 entstanden und zu einem erheblichen Ausschuss in der Produktion führten.

Außerdem kann auf speziellen Glaskugelkleber als Wärmeleitpaste zur Isolation der Elektronik zum Kühlelement verzichtet werden und stattdessen eine günstigere Wärmeleitpaste verwendet werden. Der Verzicht auf Glaskugelkleber hat außerdem den Vorteil, dass Einsparungen bei der Wartung und dem Verschleiß von Klebepumpen zum Auftragen der Wärmeleitpaste erzielt werden können. Die Glaskugeln des Glaskugelklebers verursachen bei Klebepumpen einen erhöhten Verschleiß, so dass diese beim Auftrage von Glaskugelkleber als Wärmeleitpaste häufiger gewartet und ersetzt werden müssen.

Keramische Beschichtungen zum Beschichten der Oberfläche des Kühlelements sind in verschiedenen Dicken und Materialien oder Materialkombinationen verfügbar und somit für alle Anwendungsformen weltweit einsetzbar.

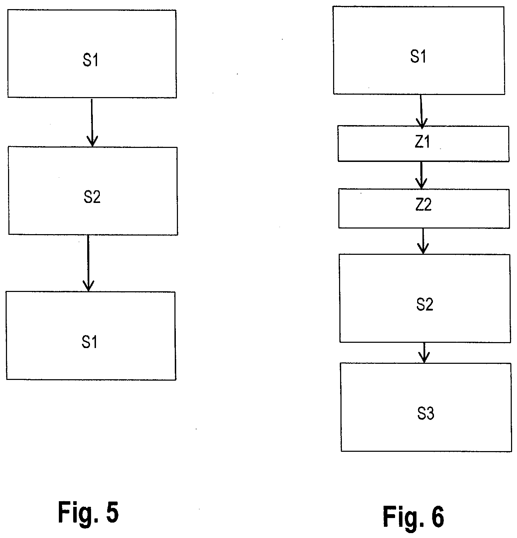

In Fig. 5 ist ein Ablaufdiagramm zum Verbinden oder Befestigen eines Elektrobauteils an einem Temperierelement, hier insbesondere Kühlelement, gemäß der ersten Ausführungsform der Erfindung gezeigt.

In einem ersten Schritt S1 wird ein Temperierelement bereitgestellt, das mit wenigstens einem Elektrobauteil zu verbinden ist, um das Elektrobauteil zu temperieren, insbesondere zu kühlen. Das Elektrobauteil soll dabei elektrisch gegenüber dem Temperierelement auf die Weise angeordnet werden, dass es von dem Temperierelement elektrisch isoliert ist.

In einem zweiten Schritt S2 wird wenigstens ein Oberflächenbereich des Temperierelements, beispielsweise eine Funktionsfläche an welcher wenigstens ein Elektrobauteil anschließend befestigt wird, mittels einer elektrisch isolierenden und thermisch leitfähigen Beschichtung, z.B. einer Keramikbeschichtung, wie einer Elektrokeramik, beschichtet.

Die elektrisch isolierende und thermisch leitfähige Beschichtung wird mittels eines thermischen Spritzverfahrens aufgebracht. Als thermisches Spritzverfahren kann dabei beispielsweise Flammspritzen, insbesondere Hochgeschwindigkeits-Flammspritzen mit einem gasförmigen Brennstoff, oder Plasmaspritzen, insbesondere Plasmaspritzen unter Atmosphäre, eingesetzt werden. Bei dem Plasmaspritzen wird die Elektrokeramik oder das Keramikmaterial zum Beschichten als Keramikgranulat mit Hochdruck in einen Plasmastrahl gesprüht, dadurch verflüssigt sich das Keramikgranulat und wird auf die zu beschichtende Oberfläche des Temperierelements aufgetragen oder aufgebracht. Als Keramikbeschichtung wie z.B. eine Elektrokeramikbeschichtung kann beispielsweise Aluminiumoxid, Korund oder Al₂O₃, ein Gemisch aus beispielsweise 97% Al₂O₃ bzw. Korund und 3% TiO₂ bzw. Titandioxid, MgAl₂O₄ oder Spinell und/oder Magnesiumoxid usw. eingesetzt werden. Die elektrisch isolierende und thermisch leitfähige Beschichtung, wie die Keramikbeschichtung, z.B. die Elektrokeramik 6, wird vorzugsweise derart auf die zu beschichtende Oberfläche des Temperierelements aufgetragen, dass z.B. eine vorhandene Oberflächenunebenheit des Temperierelements zumindest teilweise oder vollständig ausgeglichen wird und/oder eine Restunebenheit des Temperierelements beschichtet wird.

In einem dritten Schritt S3 wird wenigstens ein Elektrobauteil auf dem beschichteten Oberflächenbereich des Temperierelements angebunden, beispielsweise mittels eines thermischen Interface Materials wie einer Wärmeleitpaste, z.B. einem Glaskugelkleber oder einer anderen geeigneten Wärmeleitpaste.

Das Temperierelement kann wie zuvor beschrieben ein Gehäuse eines Kühlerlüftermotors eines Fahrzeugs sein, z.B. ein Spritzgussgehäuse, wie ein Aluminium-Spritzgussgehäuse. Die Erfindung ist aber nicht auf ein Gehäuse eines Kühlerlüftermotors eines Fahrzeugs beschränkt. Grundsätzlich kann jedes Temperierelement vorgesehen werden, das mit einem Elektrobauteil thermisch verbunden werden kann und andererseits eine elektrische Isolierung des Elektrobauteils erlaubt.

In Fig. 6 ist des Weiteren ein Ablaufdiagramm zum Verbinden oder Befestigen eines Elektrobauteils an einem Temperierelement, hier insbesondere Kühlelement, gemäß der zweiten Ausführungsform der Erfindung gezeigt.

Dabei wird in einem ersten Schritt S1 ein Temperierelement bereitgestellt, welches mit wenigstens einem Elektrobauteil zu verbinden ist, um das Elektrobauteil zu temperieren, insbesondere zu kühlen.

In einem ersten Zwischenschritt Z1 wird wenigstens ein Oberflächenbereich des Temperierelements, beispielsweise eine Funktionsfläche an welcher wenigstens ein Elektrobauteil anschließend befestigt wird, zunächst durch eine Strahltechnik behandelt. Der Oberflächenbereich wird dabei vorzugsweise derart durch die Strahltechnik behandelt, dass die Haftung der anschließenden Zwischenschicht oder der elektrisch isolierenden und thermisch leitfähigen Beschichtung, z.B. einer Elektrokeramik, erhöht wird.

Als Strahltechnik kann dabei Sandstrahlen, Kugelstrahlen, Metallstrahlen und/oder Glasstrahlen usw. eingesetzt werden, um dem Oberflächenbereich beispielsweise eine definierte Rauigkeit, z.B. in einem Bereich von RZ = 20µm bis Rz= 60µm zu verleihen und/oder um Grate und dergleichen zu entfernen. Zusätzlich oder alternativ zu dem ersten Zwischenschritt Z1 wird in einem zweiten Zwischenschritt Z2 wenigstens eine Zwischenschicht auf den wenigstens einen Oberflächenbereich des Temperierelements, beispielsweise eine Funktionsfläche an welcher wenigstens ein Elektrobauteil anschließend befestigt wird, aufgebracht. Die wenigstens eine Zwischenschicht ist dabei vorzugsweise derart gewählt, dass sie einen Haftgrund für die anschließend darauf aufzubringende elektrisch isolierende und thermisch leitfähige Beschichtung, z.B. eine Elektrokeramik, bildet. Die wenigstens eine Zwischenschicht kann dabei ebenfalls durch thermisches Spritzen auf den Oberflächenbereich des Temperierelements aufgetragen werden. Beispielsweise kann dabei als thermisches Spritzverfahren z.B. Flammspritzen, insbesondere Hochgeschwindigkeits-Flammspritzen mit einem gasförmigen Brennstoff, oder Plasmaspritzen, insbesondere Plasmaspritzen unter Atmosphäre, eingesetzt werden. Die wenigstens eine Zwischenschicht kann dabei eine Metalllegierung, beispielsweise aus Chrom, Nickel, Kupfer und/oder Aluminium, insbesondere eine Nickel-Chrom-Legierung und/oder eine Nickel-Aluminium-Legierung, sein. Des Weiteren kann die Zwischenschicht eine Dicke von z.B. 10µm aufweisen, wobei die Erfindung auf diesen Dickenwert nicht beschränkt ist.

In einem zweiten, anschließenden Schritt S2 wird der zuvor in dem Zwischenschritt Z1 mittels Strahltechnik behandelte und/oder in dem Zwischenschritt Z2 mit wenigstens einer Zwischenschicht versehene wenigstens eine Oberflächenbereich des Temperierelements mittels einer elektrisch isolierenden und thermisch leitfähigen Beschichtung, z.B. einer Elektrokeramik, beschichtet.

Die elektrisch isolierende und thermisch leitfähige Beschichtung wird mittels eines thermischen Spritzverfahrens aufgebracht. Als thermisches Spritzverfahren kann dabei beispielsweise Flammspritzen, insbesondere Hochgeschwindigkeits-Flammspritzen mit einem gasförmigen Brennstoff, oder Plasmaspritzen, insbesondere Plasmaspritzen unter Atmosphäre, eingesetzt werden. Bei dem Plasmaspritzen wird die Elektrokeramik oder das Keramikmaterial zum Beschichten als Granulat oder Keramikgranulat mit Hochdruck in einen Plasmastrahl gesprüht, dadurch verflüssigt sich das Granulat bzw. Keramikgranulat und wird auf die zu beschichtende Oberfläche des Temperierelements aufgetragen oder aufgebracht. Als Keramikbeschichtung, z.B. Elektrokeramikbeschichtung, kann, wie zuvor beschrieben, beispielsweise Aluminiumoxid, Korund oder Al₂O₃, ein Gemisch aus beispielsweise 97% Al₂O₃ bzw. Korund und 3% TiO₂ bzw. Titandioxid, MgAl₂O₄ oder Spinell und/oder Magnesiumoxid usw. eingesetzt werden. Die elektrisch isolierenden und thermisch leitfähigen Beschichtung, z.B. die Elektrokeramik 6, wird vorzugsweise derart auf die zu beschichtende Oberfläche des Temperierelements aufgetragen, dass z.B. eine vorhandene Oberflächenunebenheit des Temperierelements zumindest teilweise oder vollständig ausgeglichen wird und/oder eine Restunebenheit des Temperierelements beschichtet wird.

In einem dritten Schritt S3 wird wenigstens ein Elektrobauteil auf dem beschichteten Oberflächenbereich des Temperierelements angebunden, beispielsweise mittels eines thermischen Interface Materials wie einer Wärmeleitpaste, z.B. einem Glaskugelkleber oder einer anderen geeigneten Wärmeleitpaste.

Das Temperierelement kann wie zuvor beschrieben ein Gehäuse eines Kühlerlüftermotors eines Fahrzeugs sein, z.B. ein Spritzgussgehäuse, wie ein Aluminium-Spritzgussgehäuse. Die Erfindung ist aber nicht auf ein Gehäuse eines Kühlerlüftermotors eines Fahrzeugs beschränkt. Grundsätzlich kann jedes Temperierelement vorgesehen werden, das mit einem Elektrobauteil thermisch verbunden werden kann und andererseits eine elektrische Isolierung des Elektrobauteils erlaubt.

Um eine Oberfläche des Bauteils oder des Kühlelements mit einer definierten Rauigkeit zu versehen und/oder Grate usw. zu entfernen kann neben der genannten Strahltechnik auch jedes andere geeignete Verfahren oder jede andere geeignete Kombination von Verfahren eingesetzt werden. So kann beispielsweise Ätzen, Polieren usw. als weitere Verfahren eingesetzt werden, um nur zwei Beispiele für eine Vielzahl von Beispielen zu nennen.

## Patentansprüche

1. Temperierelement (2),
mit wenigstens einem Oberflächenbereich (11), welcher eine Oberflächenrauigkeit in einem Bereich von R_{Z} = 20µm bis R_{z} = 60µm aufweist,
mit einer elektrisch isolierenden und thermisch leitfähigen Beschichtung (6), insbesondere einer Keramikbeschichtung (6), welche auf dem Oberflächenbereich (11) vorgesehen ist,
mit wenigstens einem Elektrobauteil (1), welches auf der Beschichtung (6) befestigt ist, welches an das Temperierelement (2) thermisch angebunden ist und welches gegenüber dem Temperierelement (2) elektrisch isoliert ist.

2. Temperierelement nach Anspruch 1,
**dadurch gekennzeichnet,**
**dass** der wenigstens eine Oberflächenbereich (11) durch eine Strahltechnik, insbesondere Sandstrahlen, Kugelstrahlen, Metallstrahlen und/oder Glasstrahlen, durch Ätzen und/oder Polieren oberflächenbehandelt ist.

3. Temperierelement nach einem der vorstehenden Ansprüche, **dadurch gekennzeichnet,**
**dass** der wenigstens eine Oberflächenbereich (11) mit wenigstens einer Zwischenschicht (12) versehen ist, wobei die Zwischenschicht (12) insbesondere als Haftgrund ausgebildet ist für die Beschichtung (6).

4. Temperierelement nach Anspruch 3,
**dadurch gekennzeichnet,**
**dass** die Zwischenschicht (12) eine Metalllegierung ist und insbesondere eine Nickel, Chrom, Kupfer und/oder Aluminiumlegierung ist.

5. Temperierelement nach einem der vorstehenden Ansprüche, **dadurch gekennzeichnet,**
**dass** die Beschichtung (6) derart auf dem Oberflächenbereich (11) ausgebildet ist, um Unebenheiten (5) und/oder Unreinheiten des Oberflächenbereichs (11) zumindest teilweise oder vollständig auszugleichen.

6. Temperierelement nach einem der vorstehenden Ansprüche, **dadurch gekennzeichnet,**
**dass** das Elektrobauteil (1) mit der Beschichtung (6) mittels eines thermischen Anbindungsmaterials (4), an dem Oberflächenbereich (11) oder der wenigstens einen Zwischenschicht (12) thermisch angebunden ist, wobei das thermische Verbindungsmaterial insbesondere eine Wärmeleitpaste (4) oder ein Glaskugelkleber ist.

7. Temperierelement nach einem der vorstehenden Ansprüche, **dadurch gekennzeichnet,**
**dass** die Beschichtung (6) zumindest teilweise oder vollständig aus Aluminiumoxid, Al₂O₃, einem Gemisch aus 97% Al₂O₃ und 3% TiO₂, MgAl₂O₄ und/oder Magnesiumoxid besteht und insbesondere eine Dicke in einem Bereich zwischen 15µm bis 150µm aufweist.

8. Temperierelement nach einem der vorstehenden Ansprüche, **dadurch gekennzeichnet,**
**dass** das Temperierelement (2) als ein Kühlelement (2) ausgebildet ist, insbesondere als Gehäuse eines Lüfterkühlermotors eines Fahrzeugs.

9. Temperierelement nach einem der vorstehenden Ansprüche,
**dadurch gekennzeichnet,**
**dass** das Elektrobauteil (1) als ein elektrisches, elektronisches oder elektromechanisches Bauteil (1) ausgebildet ist, insbesondere als Transistor, Hybridschaltung, bestückte Leiterplatte (PCB), Chip, Stecker, Stator-Schaltung, Die, Stanzgitter, Leiterplatte, Feldeffekttransitor oder Spannungsregler.

10. Verfahren zum Befestigen wenigstens eines Elektrobauteils (1) an einem Temperierelement (2), mit den Schritten:
Bereitstellen eines Temperierelements (2);
Ausbilden wenigstens eines Oberflächenbereichs (11) des Temperierelements (2) mit einer Oberflächenrauigkeit in einem Bereich von R_{Z} = 20µm bis R_{z} = 60µm,
Aufbringen einer elektrisch isolierenden und thermisch leitfähigen Beschichtung (6), insbesondere einer Keramikbeschichtung (6), auf den wenigstens einen Oberflächenbereich (11) des Temperierelements (2);
Befestigen wenigstens eines Elektrobauteils (1) auf der Beschichtung (6) des Temperierelements (2), wobei das Elektrobauteil (1) thermisch an das Temperierelement (2) angebunden und elektrisch gegenüber dem Temperierelement (2) isoliert ist.

11. Verfahren nach Anspruch 10,
**dadurch gekennzeichnet,**
**dass** der Schritt des Aufbringens einer elektrisch isolierenden und thermisch leitfähigen Beschichtung (6) den Schritt aufweist: Strahlen des wenigstens einen Oberflächenbereichs (11) des Temperierelements (2) und/oder Beschichten des wenigstens einen Oberflächenbereichs (11) mit wenigstens einer Zwischenschicht (12) und
anschließend Aufbringen der elektrisch isolierenden und thermisch leitfähigen Beschichtung (6).

12. Verfahren nach Anspruch 10 oder 11,
**dadurch gekennzeichnet,**
**dass** das Aufbringen der Beschichtung (6) und/oder der Zwischenschicht (12) durch thermisches Spritzen erfolgt und insbesondere durch Hochgeschwindigkeits-Flammspritzen oder Plasmaspritzen.

13. Verfahren nach Anspruch 10, 11 oder 12,
**dadurch gekennzeichnet,**
**dass** für das Aufbringen der Beschichtung (6) vor dem Aufbringen der Beschichtung (6) ein nicht zu beschichtender Oberflächenbereich (10) des Temperierelements (2) abgedeckt oder maskiert wird.

14. Verfahren nach einem der Ansprüche 10 bis 13, **dadurch gekennzeichnet,**
**dass** der Oberflächenbereich durch eine Strahltechnik behandelt wird, um den Oberflächenbereich mit der Oberflächenrauigkeit in dem Bereich von R_{z} = 20µm bis R_{z}= 60µm zu versehen und wobei die Strahltechnik insbesondere Sandstrahlen, Kugelstrahlen, Metallstrahlen und/oder Glasstrahlen ist.

## Claims

1. Temperature-control element (2),
comprising at least one surface region (11) having a surface roughness in a range of R_{Z} = 20 µm to R_{Z} = 60 µm, comprising an electrically insulating and thermally conductive coating (6), in particular a ceramic coating (6), provided on the surface region (11),
comprising at least one electronic component (1) which is fixed to the coating (6), thermally bonded to the temperature-control element (2), and electrically insulated from the temperature-control element (2).

2. Temperature-control element according to claim 1, **characterised in that**
the at least one surface region (11) is surface-treated by blasting, in particular sand blasting, grit blasting, metal blasting and/or glass blasting, by etching and/or by polishing.

3. Temperature-control element according to any of the preceding claims,
**characterised in that**
the at least one surface region (11) is provided with at least one intermediate layer (12), the intermediate layer (12) in particular being formed as a primer for the coating (6).

4. Temperature-control element according to claim 3, **characterised in that**
the intermediate layer (12) is a metal alloy, in particular a nickel, chromium, copper and/or aluminium alloy.

5. Temperature-control element according to any of the preceding claims,
**characterised in that**
the coating (6) is formed on the surface region (11) in such a way as to compensate irregularities (5) and/or impurities in the surface region (11) at least in part or in whole.

6. Temperature-control element according to any of the preceding claims,
**characterised in that**
the electronic component (1) comprising the coating (6) is thermally bonded to the surface region (11) or the at least one intermediate layer (12) by means of a thermal bonding material (4), the thermal connection material in particular being a heat transfer paste (4) or a glass bead adhesive.

7. Temperature-control element according to any of the preceding claims,
**characterised in that**
the coating (6) consists at least in part or in whole of aluminium oxide Al₂O₃, a mixture of 97 % Al₂O₃ and 3 % TiO₂, MgAl₂O₄ and/or magnesium oxide, and in particular has a thickness in a range between 15 µm and 150 µm.

8. Temperature-control element according to any of the preceding claims,
**characterised in that**
the temperature-control element (2) is formed as a cooling element (2), in particular as a housing of a fan heatsink engine of a vehicle.

9. Temperature-control element according to any of the preceding claims,
**characterised in that**
the electronic component (1) is formed as an electric, electronic or electromechanical component (1), in particular as a transistor, hybrid circuit, populated printed circuit board (PCB), chip, plug, stator circuit, die, lead frame, printed circuit board, field effect transistor or voltage stabiliser.

10. Method for fixing at least one electronic component (1) to a temperature-control element (2), comprising the steps of:
providing a temperature-control element (2);
forming at least one surface region (11) of the temperature-control element (2) with a surface roughness in a range of R_{Z} = 20 µm to R_{Z} = 60 µm;
applying an electrically insulating and thermally conductive coating (6), in particular a ceramic coating (6), to the at least one surface region (11) of the temperature-control element (2);
fixing at least one electronic component (1) to the coating (6) of the temperature-control element (2), the electronic component (1) being thermally bonded to the temperature-control element (2), and electrically insulated from the temperature-control element (2).

11. Method according to claim 10,
**characterised in that**
the step of applying an electrically insulating and thermally conductive coating (6) comprises the step of:
blasting the at least one surface region (11) of the temperature-control element (2) and/or coating the at least one surface region (11) with at least one intermediate layer (12), and
subsequently applying the electrically insulating and thermally conductive coating (6).

12. Method according to either claim 10 or claim 11,
**characterised in that**
the coating (6) and/or intermediate layer (12) are applied by thermal spraying and in particular by highspeed flame spraying or plasma spraying.

13. Method according to claim 10, 11 or 12,
**characterised in that**
for applying the coating (6), before the coating (6) is applied a surface region (10) of the temperature-control element (2) which is not to be coated is covered or masked.

14. Method according to any of claims 10 to 13,
**characterised in that**
the surface region is treated by blasting so as to provide the surface region with the surface roughness in the range of R_{Z} = 20 µm to R_{Z} = 60 µm, the blasting in particular being sand blasting, grit blasting, metal blasting and/or glass blasting.

## Revendications

1. Élément de régulation de température (2),
comportant au moins une zone de surface (11), qui présente une rugosité de surface située dans une plage de R_{Z} = 20 µm à R_{Z} = 60 µm,
comportant un revêtement (6) électriquement isolant et thermoconducteur, en particulier un revêtement céramique (6), qui est prévu sur la zone de surface (11), comportant au moins un composant électrique (1), qui est fixé sur le revêtement (6), qui est relié thermiquement à l'élément de régulation de température (2) et qui est isolé électriquement par rapport à l'élément de régulation de température (2).

2. Élément de régulation de température selon la revendication 1,
**caractérisé en ce que**
l'au moins une zone de surface (11) est soumise à un traitement de surface par une technique de décapage par projection d'abrasif, en particulier le sablage, le grenaillage, le grenaillage avec billes de métal et/ou le grenaillage avec billes de verre, par gravure et/ou polissage.

3. Élément de régulation de température selon l'une des revendications précédentes,
**caractérisé en ce que**
l'au moins une zone de surface (11) est pourvue d'au moins une couche intermédiaire (12), la couche intermédiaire (12) étant notamment réalisée sous la forme de base d'adhérence pour le revêtement (6).

4. Élément de régulation de température selon la revendication 3,
**caractérisé en ce que**
la couche intermédiaire (12) est un alliage métallique et est en particulier un alliage de nickel, chrome, cuivre et/ou aluminium.

5. Élément de régulation de température selon l'une des revendications précédentes,
**caractérisé en ce que**
le revêtement (6) est réalisé sur la zone de surface (11) de manière à compenser au moins en partie ou complètement des aspérités (5) et/ou des impuretés de la zone de surface (11).

6. Élément de régulation de température selon l'une des revendications précédentes,
**caractérisé en ce que**
le composant électrique (1) est relié thermiquement au revêtement (6), sur la zone de surface (11) ou l'au moins une couche intermédiaire (12) au moyen d'un matériau de liaison thermique (4), le matériau de liaison thermique étant en particulier une pâte thermique (4) ou une colle contenant des billes de verre.

7. Élément de régulation de température selon l'une des revendications précédentes,
**caractérisé en ce que**
le revêtement (6) se compose au moins en partie ou complètement d'oxyde d'aluminium, d'Al₂O₃, d'un mélange de 97 % d'Al₂O₃ et de 3 % de TiO₂, de MgAl₂O₄ et/ou d'oxyde de magnésium et présente en particulier une épaisseur située dans la plage de 15 µm à 150 µm.

8. Élément de régulation de température selon l'une des revendications précédentes,
**caractérisé en ce que**
l'élément de régulation de température (2) est réalisé sous la forme d'un élément de refroidissement (12), en particulier d'un boîtier d'un moteur de radiateur de ventilateur d'un véhicule.

9. Élément de régulation de température selon l'une des revendications précédentes,
**caractérisé en ce que**
le composant électrique (1) est réalisé sous la forme d'un composant (1) électrique, électronique ou électromécanique, en particulier d'un transistor, d'un circuit hybride, d'une carte de circuit imprimée (PCB) équipée, d'une puce, d'un connecteur, d'un circuit de stator, d'un die, d'un grillage estampé, d'une carte de circuit imprimée, d'un transistor à effet de champ ou d'un régulateur de tension.

10. Procédé de fixation d'au moins un composant électrique (1) sur un élément de régulation de température (2), comprenant les étapes consistant à :
mettre à disposition un élément de régulation de température (2) ;
réaliser au moins une zone de surface (11) de l'élément de régulation de température (2) avec une rugosité de surface située dans une plage de R_{Z} = 20 µm à R_{Z} = 60 µm, appliquer un revêtement (6) électriquement isolant et thermoconducteur, en particulier un revêtement céramique (6) sur l'au moins une zone de surface (11) de l'élément de régulation de température (2) ;
fixer au moins un composant électrique (1) sur le revêtement (6) de l'élément de régulation de température (2), le composant électrique (1) étant relié thermiquement à l'élément de régulation de température (2) et isolé électriquement par rapport à l'élément de régulation de température (2).

11. Procédé selon la revendication 10,
**caractérisé en ce que**
l'étape d'application d'un revêtement (6) électriquement isolant et thermoconducteur comporte l'étape consistant à : décaper par projection d'abrasif l'au moins une zone de surface (11) de l'élément de régulation de température (2) et/ou revêtir l'au moins une zone de surface (11) d'au moins une couche intermédiaire (12) et
appliquer ensuite le revêtement (6) électriquement isolant et thermoconducteur.

12. Procédé selon la revendication 10 ou 11,
**caractérisé en ce que**
l'application du revêtement (6) et/ou de la couche intermédiaire (12) est effectuée par projection thermique et en particulier par projection à la flamme à haute vitesse ou projection au plasma.

13. Procédé selon la revendication 10, 11 ou 12,
**caractérisé en ce que**
pour l'application du revêtement (6), une zone de surface à ne pas revêtir (10) de l'élément de régulation de température (2) est recouverte ou masquée avant l'application du revêtement (6).

14. Procédé selon l'une des revendications 10 à 13,
**caractérisé en ce que**
la zone de surface est traitée au moyen d'une technique de décapage par projection d'abrasif afin de munir la zone de surface de la rugosité de surface située dans la plage de R_{Z} = 20 µm à R_{Z} = 60 µm et la technique de décapage par projection d'abrasif étant en particulier le sablage, le grenaillage, le grenaillage avec billes de métal et/ou le grenaillage avec billes de verre.
